# EUROPEAN PATENT APPLICATION

(11) **EP 2 412 519 A1**
(43) Date of publication of application: **01.02.2012**
(21) Application number: 10755644.1
(22) Date of filing: 23.03.2010
(51) Int. Cl.: B32B 15/08, H01L 21/60, H01Q 1/38, H05K 1/03, H05K 3/00, H05K 9/00

(54) **FILM WITH ATTACHED METAL LAYER FOR ELECTRONIC COMPONENTS, PRODUCTION METHOD THEREOF, AND APPLICATIONS THEREOF**

(30) Priority: 25.03.2009 JP 2009075067; 25.03.2009 JP 2009075068
(71) Applicant: Du Pont-Mitsui Polychemicals Co., Ltd., Tokyo 105-7117 (JP)
(72) Inventor: MAKI, Nobuyuki, Tokyo 105-7117 (JP); HASHIMOTO, Hidenori, Ichihara-shi Chiba 299-0108 (JP); YAMAMOTO, Yoshimasa, Ichihara-shi Chiba 299-0108 (JP)
(74) Representative: Gulde Hengelhaupt Ziebig & Schneider
(86) International application number: PCT/JP2010/002023
(87) International publication number: WO 2010/109842

(57) **Abstract**

Disclosed are a metal layer-attached film for an electronic component having an adhesive layer excellent in adhesion to a metal and excellent in the productivity, a method for producing the film, and use application of the film. The metal layer-attached film for an electronic component has a metal layer stacked on at least one surface of a resin film through an adhesive layer, wherein the adhesive layer contains an ethylene-unsaturated carboxylic acid copolymer or a metal salt thereof.

## Description

### TECHNICAL FIELD

The present invention relates to a metal layer-attached film for an electronic component, a method for producing the film and use thereof.

### BACKGROUND ART

A conventional metal layer-attached film for an electronic component is described, for example, in Patent Document 1. The document discloses a metal layer-attached film for an electronic component having an adhesive layer between a base film and a metal layer composed of a metal foil with the addition of 5 to 1 mass % of a filler having an aspect ratio of equal to or more than 20, based on 95 to 99 mass % of the base resin containing an epoxy resin, a curing agent and an elastomer.

### RELATED DOCUMENT

### PATENT DOCUMENT

Patent Document 1: Japanese Laid-open Patent Publication No. 2006-265445

### SUMMARY OF THE INVENTION

However, the related art described in the above document has a room for improvement in view of the following points.
A metal layer-attached film for an electronic component in Patent Document 1 had lower adhesion to a metal layer in an adhesive layer in some cases. So, in the electronic component using this metal layer-attached film, the metal layer was peeled off from the resin film and the like, so that the product reliability was lowered in some cases.

From the past, as an adhesive layer of a metal layer-attached film, a thermosetting resin such as an epoxy resin or the like is generally used from the viewpoint of heat resistance, and a thermoplastic resin is not used. The thermosetting resin is excellent in heat resistance, but an adhesive layer needs to be formed according to a coating method, and an adhesive solution needs to be coated, dried, cured and the like. Thus, the time for the production of a metal layer-attached film is relatively long, and there is room for improvement in the productivity including facilities. Furthermore, since an organic solvent is used for coating a conventional adhesive agent, there is room for improvement in working environment as well.

The present invention is specified by matters described in below.

[1] A metal layer-attached film for an electronic component, including a metal-containing layer attached on at least one surface of a resin film through an adhesive layer, wherein the adhesive layer contains an ethylene-unsaturated carboxylic acid copolymer or a metal salt thereof.

[2] The metal layer-attached film for an electronic component according to [1], wherein, in the ethylene-unsaturated carboxylic acid copolymer or the metal salt thereof, the ethylene-unsaturated carboxylic acid copolymer is an ethylene-(meth)acrylic acid copolymer.

[3] The metal layer-attached film for an electronic component according to [1] or [2], wherein, in the ethylene-unsaturated carboxylic acid copolymer or the metal salt thereof, a metal cation constituting the metal salt is at least one kind selected from the group consisting of Na⁺, K⁺, Li⁺, Ca²⁺, Mg²⁺, Zn²⁺, Cu²⁺, Co²⁺,Ni²⁺, Mn²⁺ and Al³⁺.

[4] The metal layer-attached film for an electronic component according to any one of [1] to [3], wherein the adhesive layer is obtained by extrusion molding the ethylene-unsaturated carboxylic acid copolymer or the metal salt thereof from a T die.

[5] The metal layer-attached film for an electronic component according to any one of [1] to [4], wherein MFR of the ethylene-unsaturated carboxylic acid copolymer or the metal salt thereof is from 0.1 to 100 g/10 minutes.

[6] The metal layer-attached film for an electronic component according to any one of [1] to [5], wherein the ethylene-unsaturated carboxylic acid copolymer or the metal salt thereof contains 1 to 30 weight % of the structural unit derived from an unsaturated carboxylic acid.

[7] The metal layer-attached film for an electronic component according to any one of [1] to [6], wherein a layer containing an anchor coating agent is provided between the resin film and the adhesive layer.

[8] The metal layer-attached film for an electronic component according to any one of [1] to [7], obtained by extrusion molding the heated ethylene-unsaturated carboxylic acid copolymer or the heated metal salt thereof from a T die to give an adhesive film, and stacking the adhesive film on the resin film.

[9] The metal layer-attached film for an electronic component according to any one of [1] to [8], wherein the metal-containing layer is a metal foil, a metal deposition film or a metal deposition layer.

[10] The metal layer-attached film for an electronic component according to any one of [1] to [8], wherein the metal-containing layer is a copper foil.

[11] The metal layer-attached film for an electronic component according to any one of [1] to [10], wherein the resin film contains at least one kind selected from the group consisting of a polyimide resin, a polyethylene naphthalene resin and a polyethylene terephthalate resin.

[12] The metal layer-attached film for an electronic component according to any one of [1] to [11], wherein the metal-containing layer constitutes a metal layer of an electronic component such as a flexible printed wiring board, an RFID antenna, a TAB tape, a COF tape, a flexible flat cable or a copper-clad stack.

[13] The metal layer-attached film for an electronic component according to any one of [1] to [11], constituting an electromagnetic wave shielding material blocking an electromagnetic wave generated from the electronic component.

[14] A method for producing a metal layer-attached film for an electronic component, including:
   heating an ethylene-unsaturated carboxylic acid copolymer or a metal salt thereof;
   forming an adhesive film by extrusion molding the melted ethylene-unsaturated carboxylic acid copolymer or the melted metal salt thereof from a T die; and
   stacking a metal-containing layer on a resin film through the adhesive film, in which these steps are continuously and repeatedly carried out.

[15] The method for producing a metal layer-attached film for an electronic component according to [14], in which a metal-containing layer is a metal foil or a metal deposition film; wherein the stacking the resin film and the metal-containing layer comprising;
   supplying the adhesive film between a long resin film and a long metal foil or a long metal deposition film, and
   pressing the resin film and the metal foil or the metal deposition film for stacking the resin film and the metal foil or the metal deposition film through an adhesive layer composed of the adhesive film.

[16] The method for producing a metal layer-attached film for an electronic component according to [14], in which the metal-containing layer is a metal deposition layer; wherein the stacking the resin film and the metal-containing layer comprising;
   depositing a metal on a surface of the adhesive film, and
   disposing a surface on which the metal of the adhesive film is not deposited to face the resin film for stacking them by pressing from both sides.

[17] The method for producing a metal layer-attached film for an electronic component according to any one of [14] to [16], including coating an anchor coating agent onto a surface on which the adhesive film of the resin film is stacked before stacking the resin film and the metal-containing layer.

[18] The method for producing a metal layer-attached film for an electronic component according to any one of [14] to [17], in which MFR of the ethylene-unsaturated carboxylic acid copolymer or the metal salt thereof is from 0.1 to 100 g/10 minutes.

[19] The method for producing a metal layer-attached film for an electronic component according to any one of [14] to [18], in which the ethylene-unsaturated carboxylic acid copolymer or the metal salt thereof contains 1 to 30 weight % of the structural unit derived from an unsaturated carboxylic acid.

[20] An RFID antenna formed by using the metal layer-attached film for an electronic component according to any one of [1] to [11] having a metal-containing layer attached on one surface of a resin film through an adhesive layer, comprising:
   an antenna formed from the metal-containing layer,
   a semiconductor chip mounted on the resin film, and
   a protective film covering the antenna and the semiconductor chip.

[21] A copper-clad stack formed by using the metal layer-attached film for an electronic component according to any one of [1] to [11] having a metal-containing layer attached on one surface of a resin film through an adhesive layer, wherein the metal layer-attached film is stacked on at least one surface of a base substrate through an adhesive layer such that the resin film is located on the base substrate side, and the metal-containing layer constitutes a patterned wiring layer.

[22] A flexible printed wiring board formed by using the metal layer-attached film for an electronic component according to any one of [1] to [11] having a metal-containing layer attached on at least one surface of a resin film through an adhesive layer, comprising:
   a wiring layer formed from the metal-containing layer,
   a protective film formed on the wiring layer and the resin film, and
   an opening exposing the wiring layer on a bottom surface which is formed on the protective film.

[23] A TAB tape formed by using the metal layer-attached film for an electronic component according to any one of [1] to [11] having a metal-containing layer attached on one surface of a resin film through an adhesive layer, comprising:
   a device hole penetrating the metal layer-attached film and
   a wiring layer formed from the metal-containing layer,
   wherein edges of the wiring layer are caused to protrude to the inside of the device hole and electrically connected to a semiconductor chip to be mounted inside the device hole.

[24] A COF tape formed by using the metal layer-attached film for an electronic component according to any one of [1] to [11] having a metal-containing layer attached on one surface of a resin film through an adhesive layer, comprising:
   a wiring layer formed from the metal-containing layer,
   wherein edges of said wiring layer are electrically connected to a semiconductor chip.

[25] A flexible flat cable formed by using the metal layer-attached film for an electronic component according to any one of [1] to [11] having a metal-containing layer attached on at least one surface of a resin film through an adhesive layer, including a wiring layer formed from the metal-containing layer, and an insulating film covering the wiring layer and the resin film.

[26] An electromagnetic wave shielding material formed by using the metal layer-attached film for an electronic component according to any one of [1] to [11] having a metal-containing layer attached on a surface of a resin film through an adhesive layer, wherein a protective layer is arranged on a surface of the metal-containing layer which is not come into contact with the adhesive layer, through a second adhesive layer.

Meanwhile, the metal layer-attached film for an electronic component of the present invention may constitute an electronic component as it is, or an electromagnetic wave shielding material blocking an electromagnetic wave generated from the electronic component, and may be used for any of these uses.

### ADVANTAGEOUS EFFECT OF THE INVENTION

The metal layer-attached film for an electronic component according to the present invention is provided with an adhesive layer composed of a predetermined thermoplastic resin, and is excellent in adhesion to a metal-containing layer (hereinafter referred to as the metal layer) such as a metal foil or the like and also excellent in adhesion to a resin film. Accordingly, adhesion between the resin film and the metal layer is improved. The product reliability using the metal layer-attached film may be improved. Also, the adhesive layer of the metal layer-attached film of the present invention is a thermoplastic resin, so that an adhesive film may be continuously formed by extrusion from a T die. Thus, the metal layer-attached film of the present invention can be continuously produced by supplying the adhesive film between the resin film and the metal layer and pressing them, and it is thus very excellent in the productivity.

### BRIEF DESCRIPTION OF THE DRAWINGS

The above and other objects, advantages and features of the present invention will be more apparent from the following description of certain preferred embodiments taken in conjunction with the accompanying drawings, in which:

Fig. 1 is a cross-sectional view schematically illustrating a one-sided metal layer-attached film for an electronic component according to this embodiment.
Fig. 2 is a view schematically illustrating a part of a method for producing a one-sided metal layer-attached film for an electronic component according to this embodiment.
Fig. 3 is a cross-sectional view schematically illustrating a double-sided metal layer-attached film for an electronic component according to this embodiment.
Fig. 4(a) is a top view schematically illustrating an RFID antenna using a metal layer-attached film for an electronic component according to this embodiment, while Fig. 4(b) is a cross-sectional view along the A-A line of Fig. 4(a).
Fig. 5 is a cross-sectional view schematically illustrating a copper-clad stack using a metal layer-attached film for an electronic component according to this embodiment.
Fig. 6(a) is a cross-sectional view schematically illustrating a one-sided flexible printed wiring board using a one-sided metal layer-attached film for an electronic component according to this embodiment, while Fig. 6(b) is a cross-sectional view schematically illustrating a double-sided flexible printed wiring board using a double-sided metal layer-attached film for an electronic component according to this embodiment.
Fig. 7 is a cross-sectional view schematically illustrating a TAB tape using a metal layer-attached film for an electronic component according to this embodiment.
Fig. 8 is a cross-sectional view schematically illustrating a COF tape using a metal layer-attached film for an electronic component according to this embodiment.
Fig. 9 is a cross-sectional view schematically illustrating an electromagnetic wave shielding material according to this embodiment.
Fig. 10(a) is a front view schematically illustrating an electromagnetic wave shielding material for PDP according to this embodiment, while Fig. 10(b) is a cross-sectional view along the B-B line of Fig. 10(a).

### DESCRIPTION OF EMBODIMENTS

Embodiments of the present invention will be illustrated with reference to the drawings below. Incidentally, in all drawings, the same components are assigned the same reference numerals and appropriate explanations thereof will not be repeated.

### Metal Layer-Attached Film

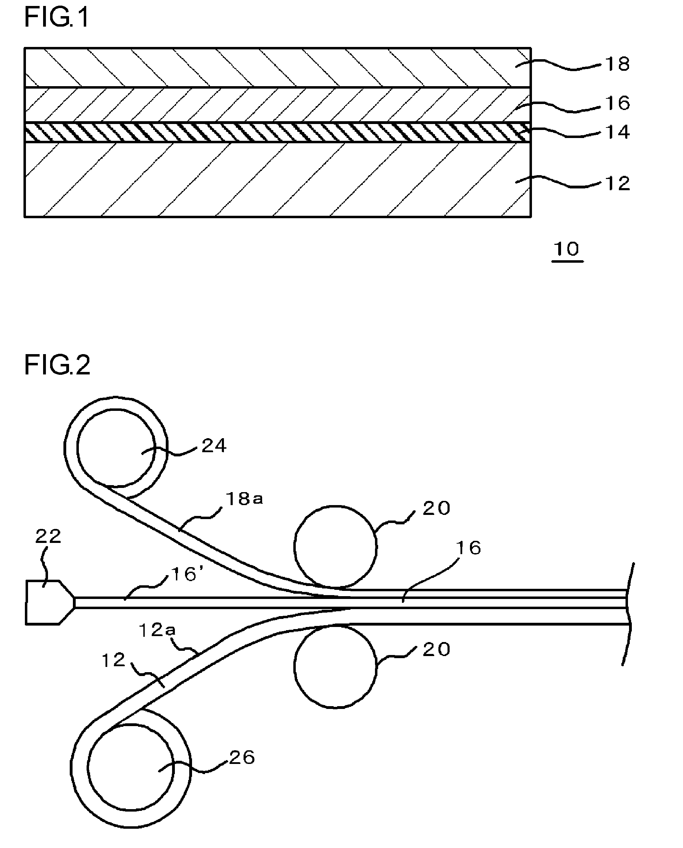

As shown in Fig. 1, a metal layer-attached film for an electronic component 10 of this embodiment is obtained by stacking a resin film 12, a layer containing an anchor coating agent (hereinafter referred to as the anchor coating layer 14), an adhesive layer 16 and a metal layer 18 in this order. The metal layer 18 is a metal foil, a metal deposition film or a metal deposition layer, and may be suitably selected depending on the use or the like.

The metal foil may contain nickel, copper, silver, aluminum or the like, and may be selected depending on the purpose such as electrical properties, processability or the like. The film thickness of the metal foil is from about 30 to 150 µm.
As the metal deposition film, there may be used a metal layer-forming film in which the thin film layer composed of a metal as described above is formed on the resin film of various base materials, for example, a polyester film, a polyamide film, a polyimide film or the like by a sputtering method, a vacuum deposition method, a plating method or the like. The film thickness of the metal deposition film is from about 30 to 150 µm.
The metal deposition layer is a metal layer in which the thin film layer composed of a metal as described above is formed on the adhesive layer 16 of a base material composed of the resin film 12 and the adhesive layer 16 (the anchor coating layer 14 may be arranged, as necessary, on the resin film 12) by a sputtering method, a vacuum deposition method, a plating method or the like. The film thickness of the metal deposition layer is from about 50 nm to 1 µm.

The resin film 12 may contain a heat resistant resin such as a poly-p-phenylene terephthalamide resin (PPTA), a polyethylene terephthalate resin (PET), a polyethylene naphthalate resin (PEN), a polyimide resin, a polyphenylene sulfide resin, a polyether ether ketone resin (PEEK), various liquid crystalline polymers (LCPs), a polyolefin resin or the like.
In this embodiment, it is preferable that the resin film 12 contains a polyimide resin or PET from the viewpoint of improvement of suitable heat resistance. The thickness of the resin film 12 is from about 2 to 100 µm and preferably from about 5 to 60 µm.

The adhesive layer 16 in this embodiment contains an ethylene-unsaturated carboxylic acid copolymer or a metal salt thereof. When the adhesive layer 16 contains such a resin, adhesion to the metal layer 18 is improved and the product reliability is improved. In specifically, as the amount of the carboxylic acid becomes high, adhesion to the metal layer 18 is further improved. The thickness of the adhesive layer 16 is from about 5 to 50 µm.

The ethylene-unsaturated carboxylic acid copolymer used in this embodiment is a copolymer of ethylene and an unsaturated carboxylic acid. Examples of the unsaturated carboxylic acid include an unsaturated carboxylic acid having 3 to 8 carbon atoms, specifically, acrylic acid, methacrylic acid, itaconic acid, maleic acid anhydride, maleic acid monomethyl ester, maleic acid monoethyl ester and the like. Among these unsaturated carboxylic acids, particularly preferably used are acrylic acid and methacrylic acid.

Meanwhile, the ethylene-unsaturated carboxylic acid copolymer may be a multi-component copolymer composed of three or more components, or may be copolymerized with, in addition to the above components capable of copolymerizing with ethylene, unsaturated carboxylic acid esters such as methyl acrylate, ethyl acrylate, isobutyl acrylate, n-butyl acrylate, isooctyl acrylate, methyl methacrylate, isobutyl methacrylate, dimethyl maleate, diethyl maleate and the like; vinyl esters such as vinyl acetate, vinyl propionate and the like; unsaturated hydrocarbons such as propylene, butene, 1,3-butadiene, pentene, 1,3-pentadiene, 1-hexene and the like; oxides such as vinyl sulfate, vinyl nitrate and the like; halogen compounds such as vinyl chloride, vinyl fluoride and the like; vinyl group-containing primary and secondary amine compounds; carbon monoxide, sulfur dioxide and the like as a third component.

The metal salt of the ethylene-unsaturated carboxylic acid copolymer (ionomer) used in this embodiment is obtained by cross-linking at least a part of the carboxyl group in the ethylene-unsaturated carboxylic acid copolymer with a metal cation.

Examples of the metal cation for crosslinking the ethylene-unsaturated carboxylic acid copolymer include monovalent-trivalent cations such as Na⁺, K⁺, Li⁺, Ca²⁺, Mg²⁺, Zn²⁺, Cu²⁺, Co²⁺, Ni²⁺, Mn²⁺, Al³⁺ and the like. These may be used singly or in combination of two or more kinds.

A proper ionomer is an ionomer in which a copolymer of ethylene and an unsaturated carboxylic acid synthesized by the high-pressure radical polymerization method serving as a base is neutralized with 10 to 90% of a cation.

The ethylene-unsaturated carboxylic acid copolymer or the metal salt thereof contains 1 to 30 weight % and preferably 2 to 20 weight % of the structural unit derived from an unsaturated carboxylic acid. Accordingly, adhesion between the adhesive layer 16 and the metal layer 18, and molding processability of the metal layer-attached film are well balanced. In addition, from the viewpoint of improvement of adhesion between the adhesive layer 16 and the metal layer 18, it is also preferable that an unsaturated carboxylic acid copolymer is separately added in the ranges in which molding processability is not affected.

Furthermore, the melting point of the ethylene-unsaturated carboxylic acid copolymer or the metal salt thereof is generally from about 70 to 110 degrees centigrade. In consideration of a technological property of fashioning or the like, the melt flow rate (MFR, JIS K7210-1999 (190 degrees centigrade, a load of 2, 160 g), hereinafter, the same) of the ethylene-unsaturated carboxylic acid copolymer or the metal salt thereof may be from 0.1 to 100 g/10 minutes and preferably from 0.5 to 50 g/10 minutes.

Furthermore, the adhesive layer 16 may contain, in addition to the ethylene-unsaturated carboxylic acid copolymer or the metal salt thereof, an additive such as an anti-oxidant, a stabilizer, a lubricant, an adhesive agent, a coloring agent or the like.

The anchor coating agent used in the embodiment may be selected from anchor coating agents such as a titanium anchor coating agent including alkyl titanate or the like, a polyurethane anchor coating agent, a polyester anchor coating agent, a polyethyleneimine anchor coating agent, a polyisocyanate anchor coating agent and the like. The anchor coating agents are not restricted thereto, and may be properly selected according to the use. The anchor coating agent may be one-component solvent type, two-component solvent type or three-component solvent type, and in addition thereto, may be solvent-free aqueous type.

These anchor coating agent may be properly selected from commercial products. Furthermore, it may be selected according to the object of the present invention from commercial products as a coating agent. Examples of the commercial product include TITA BOND (product name, commercially available from Nippon Soda Co., Ltd., T-19, T-120, etc.), ORGATIX (product name, sold by Matsumoto Trading Co., Ltd., PC-105, etc.), TAKELAC/TAKENATE (product name, commercially available from Mitsui Chemicals Polyurethanes, Inc., A-3200/A-3003, A-968/A-8, etc.), SEIKA BOND (product name, commercially available from Dainichiseika Color & Chemicals Mfg. Co., Ltd., A-141/C-137, E-263/C-26, etc.), SEIKADYNE (product name, commercially available from Dainichiseika Color & Chemicals Mfg. Co., Ltd., 2710A/2710B, 2730A/2730B/DEW I, 2710A/2810C/DEW I, etc.), BONDEIP (commercially available from Active Business Studio, PA100, PM), LX-415, etc. (product name, commercially available from DIC Corporation) and the like.

Furthermore, some of the commercial anchor coating agents are commercially used as an adhesive agent imparted with antistatic properties (for example, BONDEIP PA100), so that such anchor coating agents may be used.

In this embodiment, the resin film 12 having the anchor coating layer 14 may be obtained by coating the anchor coating agent onto the resin film 12 in an in-line or off-line manner. The thickness of the anchor coating layer 14 is usually from about 0.01 to 5 µm and particularly preferably from about 0.01 to 1.0 µm.
Furthermore, the surface of the resin film 12 before the formation of the anchor coating layer 14 or the surface of the anchor coating layer 14 may be subjected to an ozone treatment, a plasma treatment, a corona discharge treatment, a flame treatment or the like.

### Method for Producing Metal Layer-Attached Film for Electronic Component

The metal layer-attached film for an electronic component 10 of this embodiment can be obtained by carrying out a step of forming the adhesive layer 16 according to an extrusion lamination method from a T die, or a dry lamination method such as a thermal lamination method, a heat sealing method, a heat press method or the like.

In this embodiment, since the melting point and the melt flow rate of the ethylene-unsaturated carboxylic acid copolymer or the metal salt thereof are within the above range, the metal layer-attached film can be continuously produced by the extrusion lamination method from a T die, and the productivity of the metal layer-attached film is thus highly improved.

In this embodiment, a method for producing a metal layer-attached film for an electronic component includes a step of heating an ethylene-unsaturated carboxylic acid copolymer or a metal salt thereof; a step of forming an adhesive film by extrusion molding the melted ethylene-unsaturated carboxylic acid copolymer or the melted metal salt thereof from a T die; and a step of stacking a metal-containing layer onto a resin film (hereinafter also referred to as the metal layer) through the adhesive film, in which these steps may be continuously and repeatedly carried out.

In this embodiment, when the metal layer 18 is a metal foil or a metal deposition film, the metal layer-attached film 10 can be continuously produced by repeatedly carrying out the following steps (a) to (c) . Incidentally, in this embodiment, the metal layer 18 formed from a metal foil is exemplified, but it can also be produced in the same method with the use of a metal deposition film instead of the metal foil.

Step (a): heating an ethylene-unsaturated carboxylic acid copolymer or a metal salt thereof.
Step (b): forming an adhesive film by extrusion molding the melted ethylene-unsaturated carboxylic acid copolymer or the melted metal salt thereof from a T die.
Step (c) : supplying the adhesive film between a long resin film and a long metal foil.
Step (d): pressing a resin film and a metal foil for stacking the resin film and the metal foil through an adhesive layer composed of the adhesive film.
Accordingly, a metal layer-attached film for an electronic component can be continuously produced without requiring complicated steps, and is excellent in the productivity.

One example of the aforementioned respective steps will be described in detail below, but the production method of the present invention is not limited thereto, and various modifications can be made as long as they are in the scope of the production method of the present invention.

### Step (a)

First, in an extrusion stacking equipment, the ethylene-unsaturated carboxylic acid copolymer or the metal salt thereof is heated to a predetermined temperature so as to melt the same, resulting in improving the fluidity of the resin.

The extrusion temperature during the extrusion stacking process is different depending on the kind of the resin, but it is preferably in the range of 250 to 350 degrees centigrade and particularly preferably in the range of 280 to 330 degrees centigrade as a resin temperature measured directly under the T die.

### Steps (b) and (c)

First, in the step (b), as shown in Fig. 2, the melted resin in the step (a) is extruded from a T die 22 and formed into a film shape. Then, an extruded adhesive film 16' is fed to a stack unit having a pair of rolls 20, and then supplied between the resin film 12 composed of a long heat resistant resin and a long metal foil 18a (step (c)).
The resin film 12 is unwound from a roll 26 and supplied between the rolls 20. A surface 12a on which the adhesive layer 16 of the resin film 12 is intended to be formed may be coated with an anchor coating agent and may have an anchor coating layer (not shown in the drawings) . Adhesion between the resin film 12 and the adhesive layer 16 is further improved by means of the anchor coating layer.

Specifically, the anchor coating agent is applied onto the surface 12a of the resin film 12 using a coating apparatus attached above the extrusion stacking equipment, and the resin film 12 in which a diluting solvent used as the anchor coating agent is dried with a dryer is fed to the stack unit at a fixed speed. The metal foil 18a is also unwound from a roll 24 and supplied between the rolls 20.

### Step (d)

In the step (d), the extruded adhesive film 16' supplied between the pair of rolls 20 of the stack unit, the anchor coating layer 14-attached resin film 12 and the metal foil 18a are pressed between the rolls 20 to produce a metal layer-attached film in which, as illustrated in Fig. 1, the resin film 12, the anchor coating layer 14, the adhesive layer 16 and the metal foil 18a are stacked in this order. The stack unit having the rolls 20 may be at atmospheric pressure or under reduced pressure. Formation of voids inside the adhesive layer 16 or between layers may be suppressed by molding under reduced pressure. The pair of rolls 20 may be heated.
Furthermore, a metal layer-attached film may be formed by further arranging a heating and cooling unit after pressing between the pair of rolls 20.

On the other hand, when the metal layer is a metal deposition layer, the metal layer-attached film for an electronic component 10 can be continuously produced by repeatedly carrying out the following steps (A) to (D).
Step (A): heating an ethylene-unsaturated carboxylic acid copolymer or a metal salt thereof.
Step (B): forming an adhesive film by extrusion molding the melted ethylene-unsaturated carboxylic acid copolymer or the melted metal salt thereof from a T die.
Step (C): depositing a metal on a surface of the adhesive film.
Step (D): disposing a surface on which the metal of the adhesive film is not deposited to face the resin film for stacking them by pressing from both sides.
Accordingly, a metal layer-attached film for shielding an electromagnetic wave can be continuously produced without requiring complicated steps, and is excellent in the productivity.
Meanwhile, the steps (A) and (B) may be carried out in the same method as in steps (a) and (b).

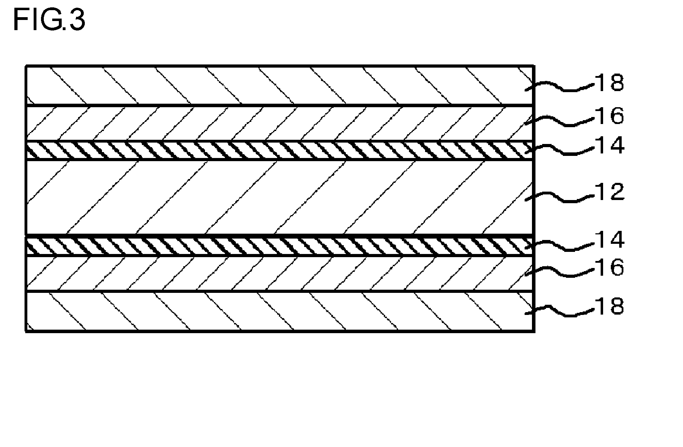

As described above, the embodiments of the present invention have been described with reference to the drawings, but the embodiments are examples of the present invention and other various constructions can also be adopted.
For example, as shown in Fig. 3, a double-sided metal layer-attached film obtained by stacking an anchor coating layer 14 containing an anchor coating agent, an adhesive layer 16 and a metal layer 18 in this order may be formed on both surfaces of a resin film 12.
The double-sided metal layer-attached film may be obtained by stacking each surface of the resin film 12 alternately to the metal layer 18 in the device of Fig. 2. However, from the viewpoint of the production efficiency, the metal layer 18 and the adhesive film 16' may be supplied to both surfaces of the resin film 12 to form a double-sided metal layer-attached film at one time as well by constructing a device capable of supplying the metal layer 18 and the adhesive film 16'.

### Use application

The metal layer-attached film for an electronic component 10 of this embodiment may be used as an element mounting board or an electrical wiring board in an electronic component. Concrete examples of the electronic components include a radio frequency identification (RFID) antenna, a copper-clad stack, a flexible printed wiring board, a tape automated bonding (TAB) tape, a chip on film (COF) tape, a flexible flat cable and the like.
Furthermore, the metal layer-attached film for an electronic component 10 of this embodiment may also constitute an electromagnetic wave shielding material blocking an electromagnetic wave generated from an electronic component.
Hereinafter, the above-mentioned various electronic components and the electromagnetic wave shielding material will be described in detail.

### RFID Antenna

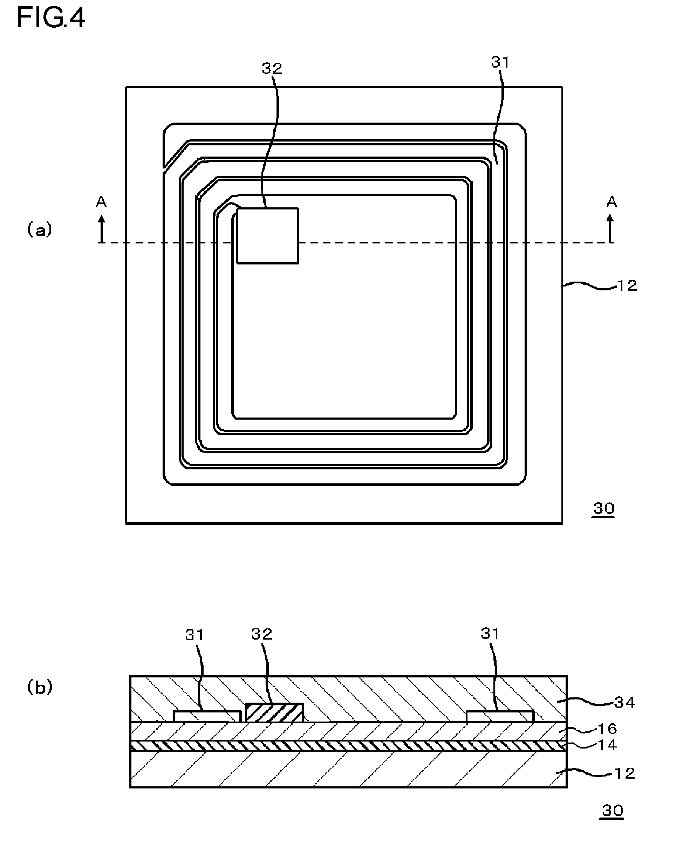

Fig. 4(a) illustrates a schematic top view of an RFID antenna according to this embodiment. The metal layer-attached film for an electronic component of this embodiment may be used as an RFID antenna substrate. Fig. 4(a) illustrates an antenna 31 and a semiconductor chip 32 on a resin film 12 without illustrating a protective film 34 in the drawings. Fig. 4(b) is a cross-sectional view along the A-A line of Fig. 4(a).

As shown in Figs. 4 (a) and (b), an RFID antenna 30 has the antenna 31 on the resin film 12 serving as a base. The antenna 31 may be formed by subjecting the metal layer, for example, a metal foil 18a, to steps of usual exposure, development, etching and the like. Then, the semiconductor chip 32 is mounted on the resin film 12. The antenna 31 and the semiconductor chip 32 are electrically connected. Further, the protective film 34 protecting the antenna 31 and the semiconductor chip 32 is stacked.
The protective film 34 is a base material and an adhesive layer, and protects the antenna 31 and the semiconductor chip 32 by overlaying, press bonding and curing the adhesive layer and the antenna 31. As the adhesive layer of the protective film 34, the same adhesive layer as the aforementioned adhesive layer 16 may be used.

### Copper-Clad stack

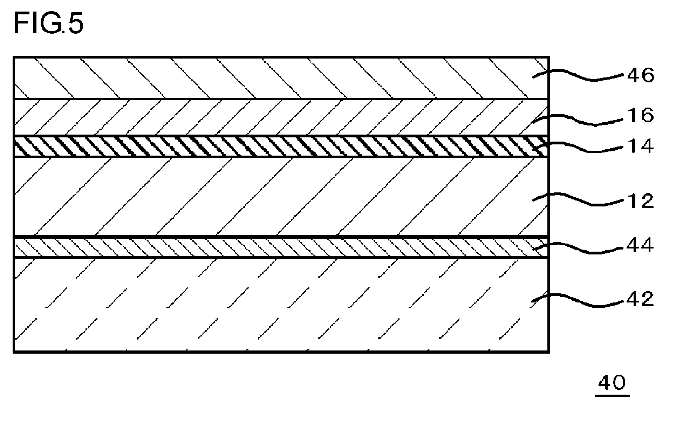

Fig. 5 illustrates a schematic cross-sectional view of a copper-clad stack according to this embodiment.
As shown in Fig. 5, a copper-clad stack 40 of this embodiment is a rigid base substrate 42 and a metal layer-attached film for an electronic component of this embodiment in which a resin film 12 is stacked on the base substrate 42 through an adhesive layer 44 so as to be located on the base substrate 42, while a wiring layer 46 is formed by subjecting the metal layer, for example, a metal foil 18a, to steps of usual exposure, development, etching and the like.
Meanwhile, the metal layer-attached film for an electronic component 10 of the embodiment may be stacked to form a multilayered structure. Also, the metal layer-attached film for an electronic component 10 may also be stacked on both surfaces of the base substrate 42 to form a double-sided copper-clad stack.

### Flexible Printed Wiring Board

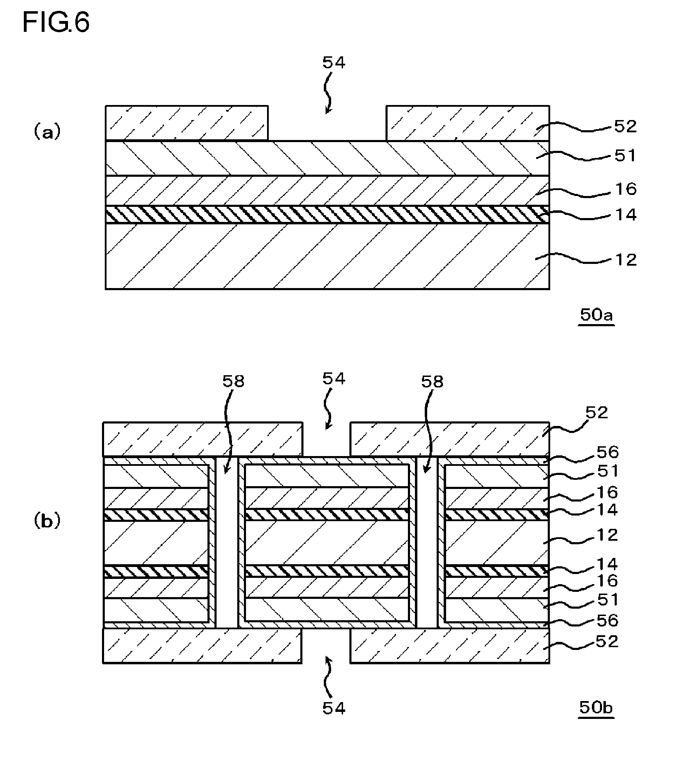

Fig. 6(a) illustrates a schematic cross-sectional view of a one-sided flexible printed wiring board according to this embodiment.
As shown in Fig. 6(a), a one-sided flexible printed wiring board 50a of this embodiment is a wiring layer 51 formed from a metal layer 18 and a protective film 52 stacked through an adhesive layer. The wiring layer 51 is formed by subjecting the metal layer, for example, a metal foil 18a, to steps of usual exposure, development, etching and the like. The protective film 52 has an opening 54 exposing the wiring layer 51 on its bottom surface. The protective film 52 is a base material and an adhesive layer, and protects the wiring layer 51 by overlaying, press bonding and curing the adhesive layer and the wiring layer 51. As the adhesive layer of the protective film 52, the same adhesive layer as the aforementioned adhesive layer 16 may be used.

Fig. 6(b) illustrates a schematic cross-sectional view of a double-sided flexible printed wiring board according to this embodiment. The double-sided flexible printed wiring board can be obtained by using the double-sided metal layer-attached film illustrated in Fig. 3.
As shown in Fig. 6(b), a double-sided flexible printed wiring board 50b of this embodiment is a through hole 58 penetrating a base film (a double-sided metal layer-attached film), wiring layers 51, 51 formed from metal layers on both surfaces, for example, metal foils 18a, 18a, plating layers 56 electrically connecting wiring layers 51, 51 on both surfaces, and protective films 52, 52 stacked through an adhesive layer.

### TAB Tape

A TAB tape is a technology for automation and increase of speed in mounting a semiconductor element such as IC, LSI or the like. The TAB tape is to connect a substrate and a semiconductor element by connecting pads of the substrate, pads of the outer lead, pads of the inner lead and pads of the semiconductor element all at once with the use of a copper foil-attached film (also called a tape because of its long shape) in which a copper lead containing an inner lead and an outer lead is formed on the film by etching a metal layer, for example, a copper foil, attached above a flexible insulating film (corresponding to the resin film in the present invention) such as a long polyimide or the like.

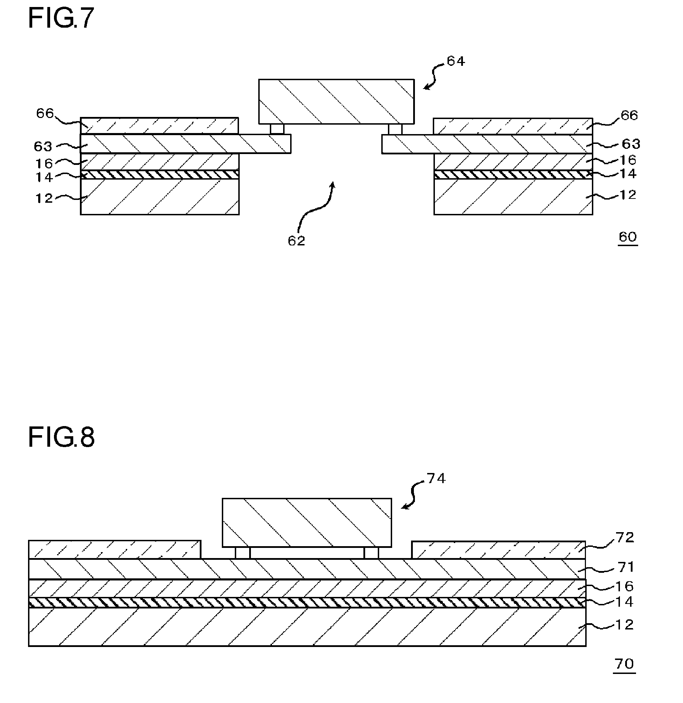

Fig. 7 illustrates a schematic cross-sectional view of a TAB tape according to this embodiment.
As shown in Fig. 7, a TAB tape 60 is a device hole 62 penetrating a metal layer-attached film of this embodiment, and a copper lead (wiring layer) 63 containing an inner lead and an outer lead formed from a metal layer 18 composed of a metal foil. A resist layer 66 opening the device hole 62 is provided on the copper lead 63. An inner lead unit of the copper lead 63 is caused to protrude to the inside of the device hole 62, and is electrically connected to a semiconductor chip 64 mounted inside the device hole 62.

### COF Tape

A COF tape is a tape to be used as a result of the requirements of formation of much finer wiring with high precision of a liquid crystal display screen of a personal computer or a cellular phone, and has fundamentally the same structure as the TAB tape except that a device hole is not formed in a plastic insulating film.

Fig. 8 illustrates a schematic cross-sectional view of a COF tape 70 according to this embodiment.
As shown in Fig. 8, the COF tape 70 is provided with a wiring layer 71 formed from a metal layer 18 composed of, for example, a metal foil. On the wiring layer 71 is arranged a resist layer 72 opening a portion on which a semiconductor chip 74 is mounted. Edges of the wiring layer 71 are electrically connected to the semiconductor chip 74.

### Flexible Flat Cable

A flexible flat cable of this embodiment can be obtained by subjecting a metal layer 18 composed of, for example, a metal foil in the metal layer-attached film for an electronic component of this embodiment, to steps of usual exposure, development, etching and the like to form an approximately linear wiring layer in the longitudinal direction, and stacking an insulating film covering the wiring layer and a resin film 12 through an adhesive layer. As the adhesive layer of the insulating film, the same adhesive layer as the aforementioned adhesive layer 16 may be used.

In this embodiment, the adhesive layer 16 contains an ethylene-unsaturated carboxylic acid copolymer or a metal salt thereof, so that adhesion between the adhesive layer 16 and the metal layer 18 is improved, and the product reliability of the electronic component is improved. Furthermore, the adhesive layer of a protective film or an insulating film in this embodiment may have the same configuration as the aforementioned adhesive layer 16, so that adhesion between the metal layer 18 and the protective film or the insulating film is improved, and the product reliability of the electronic component is further improved.

Meanwhile, it is illustrated by way of a structure in which at least a resin film in this embodiment, an adhesive layer and a metal layer are stacked in this order. However, when various electronic components are to be configured, as the metal layer that is a metal-containing layer, a resin composition in combination with a metal filler may be used, or this metal filler, instead of the metal layer, may also be dispersed in at least one of the resin film 12 and the adhesive layer 16.

### Electromagnetic Wave Shielding Material

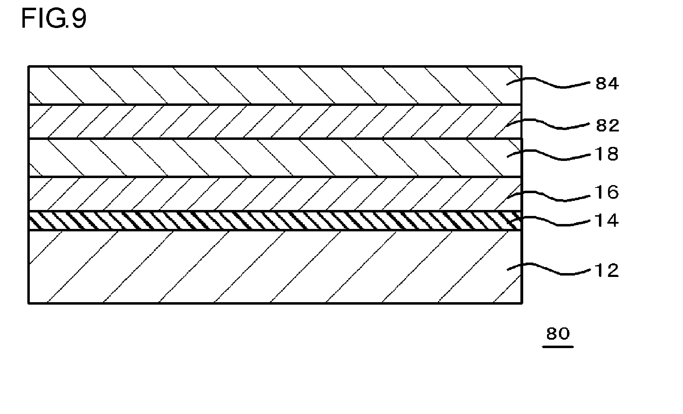

The metal layer-attached film for an electronic component of this embodiment may be used as a metal layer-attached film for shielding an electromagnetic wave, and may be specifically used for a first electromagnetic wave shielding material 80 as shown in Fig. 9. A metal layer 18 functions as an electromagnetic wave absorption layer, and may be selected among metal species depending on the purpose, for example, frequency band of an electromagnetic wave, processability or the like.
The first electromagnetic wave shielding material 80 may be used as, in hospitals, various equipment rooms or the like, various building materials used for a ceiling, a wall, a floor and the like, films attached above windows, roll screens; electromagnetic wave partition curtain films covering the periphery of a device generating an electromagnetic wave; main bodies of a cellular phone, a personal computer, a microwave oven, a plasma television, a cathode ray tube (CRT) television, various electrical devices using electro luminescence (EL); and clothes of workers handling an equipment generating an electromagnetic wave.

As shown in Fig. 9, when the metal layer-attached film for an electronic component of this embodiment is used as the first electromagnetic wave shielding material 80, a protective layer for protecting the metal layer 18, for example, a protective layer composed of a resin film 84, may be formed on a surface on which the adhesive layer 16 of the metal layer 18 composed of, for example, a metal foil is not formed, for the purpose of improving scratch resistance, weather resistance and durability, or improving appearance. In that case, a second adhesive layer 82 may be formed on the metal layer 18 in the same manner as in the adhesive layer 16, and the resin film 84 may be attached thereto. The resin materials exemplified in the adhesive layer 16 are applied to the second adhesive layer 82. Also, as a method of attaching and stacking the metal layer 18 to the protective resin film 84 through the second adhesive layer 82, the same method as the method of attaching and stacking the resin film 12, the adhesive layer 16 and the metal layer 18 described above may be applied. Accordingly, an electromagnetic wave shielding material containing a protective layer can be stably and continuously produced without using an organic solvent by the melt extrusion lamination method, thus achieving production with a low environmental load.
Incidentally, depending on the use, other functional films or the like may also be formed on a back surface of the resin film 12 or an upper surface of the resin film 84 or further between the metal layer 18 and the resin film 84.

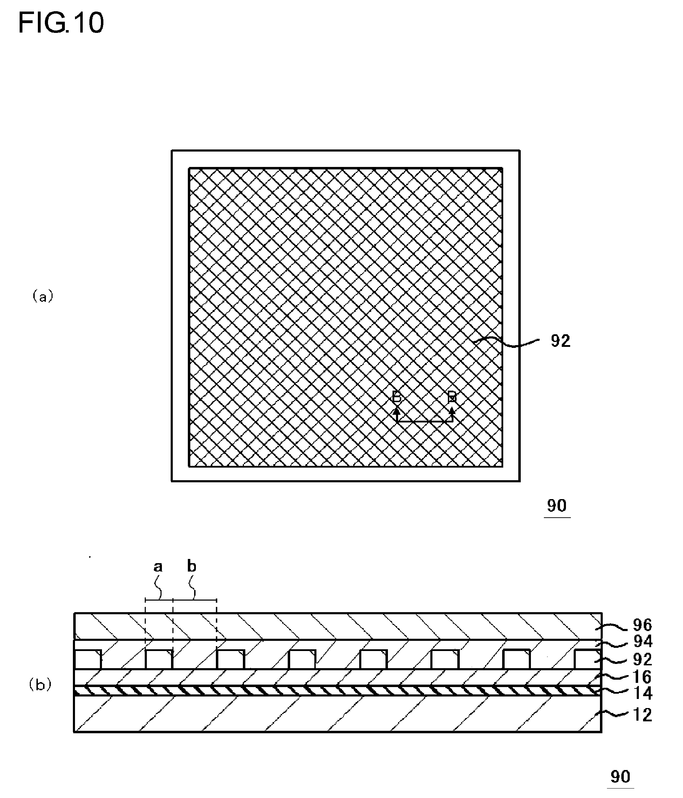

Meanwhile, the metal layer-attached film for an electronic component of this embodiment may be used for a second electromagnetic wave shielding material 90 as shown in Fig. 10. The second electromagnetic wave shielding material 90 may be used for an electromagnetic wave shielding film attached above a display generating an electromagnetic wave using plasma display panel (PDP), cathode ray tube (CRT), electro luminescence (EL) or the like; and an electromagnetic wave shielding film attached above a window of an electronic cooker such as a microwave oven or the like. Also, the second electromagnetic wave shielding material 90 may also be used as, as described above, in hospitals, various equipment rooms or the like, films attached above windows, roll screens; partition curtain films covering the periphery of a device generating an electromagnetic wave, and the like.

Fig. 10(a) illustrates a schematic front view of a second electromagnetic wave shielding material according to this embodiment. Fig. 10 (b) is a cross-sectional view along the B-B line of Fig. 10(a). The metal layer-attached film for an electronic component of this embodiment may be used as a substrate for shielding an electromagnetic wave.
As shown in Figs. 10(a) and (b), the second electromagnetic wave shielding material 90 is provided with a metal mesh layer 92 on a resin film 12 serving as a base. A metal line width a in the metal mesh layer 92 is about 20 µm, while a line pitch b between metal wires is about 200 µm. The metal mesh layer 92 may be formed by subjecting the metal layer, for example, a metal foil 18a, to steps of usual exposure, development, etching and the like, or may be formed by forming a metal foil in a metal mesh structure and stacking its metal mesh to an adhesive layer 16. Furthermore, a functional film 96 is stacked on the metal mesh layer 92 through an adhesive layer 94. As the adhesive layer 94, the same adhesive layer as the aforementioned adhesive layer 16 may be used. The functional film 96 may be used as an antireflection film, a protective film or the like depending on the use.
Incidentally, depending on the use application, other functional films or the like may also be formed on a back surface of the resin film 12 or an upper surface of the functional film 96, or further between the metal mesh layer 92 and the functional film 96.

In this embodiment, the adhesive layer 16 contains an ethylene-unsaturated carboxylic acid copolymer or a metal salt thereof, so that adhesion between the adhesive layer 16 and the metal layer 18 composed of, for example, a metal foil, is improved. So, when the metal layer-attached film is used for an electromagnetic wave shielding material, there is little risk of lowering shielding performance by peeling off the metal layer, for example, a metal foil (or the metal mesh layer) in a use environment, and the product reliability is improved. Furthermore, when a second adhesive layer is formed on the metal foil in order to form a protective film on the metal layer, adhesion between the metal layer 18 and the protective film is improved, and the product reliability of the electromagnetic wave shielding material is further improved by constructing the second adhesive layer in the same manner as in the adhesive layer 16. Even when the functional film 96 is stacked through the adhesive layer 94, adhesion between the metal mesh layer 92 and the functional film 96 is improved, and the product reliability of the electromagnetic wave shielding material is further improved by constructing the adhesive layer 94 in the same manner as in the adhesive layer 16.

Meanwhile, it is illustrated by way of a structure in which at least a resin film in this embodiment, an adhesive layer and a metal layer are stacked in this order. However, when the metal layer-attached film is used as an electromagnetic wave shielding material, a resin composition in combination with a metal filler allowing the metal layer to exhibit an electromagnetic wave absorption effect may be used, or this metal filler, instead of the metal-containing layer, may also be dispersed in at least one of the resin film 12 and the adhesive layer 16.

### EXAMPLES

The present invention is now illustrated in detail below. However, the present invention is not restricted to these Examples.

### Raw Materials

Polyimide film: Kapton 100H (product name, thickness: 25 µm, commercially available from Toray Industries, Inc.)
PET film (a): Lumirror P60C (product name, thickness: 100 µm, commercially available from Toray Industries, Inc.)
PET film (b): Tetoron G2C (product name, thickness: 25 µm, commercially available from Teijin Dupont Films Ltd.)
PEN film: Teonex Q51C (product name, thickness: 25 µm, commercially available from Teijin Dupont Films Ltd.)

### AC Agent

AC agent (AC-a): Seikadyne 2710A (1 weight part), Seikadyne 2710C (2 weight parts) (a product of Dainichiseika Color & Chemicals Mfg. Co., Ltd.)
AC agent (AC-b): Seikadyne 2710A (1 weight part), Seikadyne 2810C(T) (4 weight parts), DEW I (0.25 weight parts) (a product of Dainichiseika Color & Chemicals Mfg. Co., Ltd.)

### Adhesive Agent

Adhesive agent (a): An ethylene-methacrylic acid copolymer, content of the methacrylic acid in the copolymer: 4 weight %, MFR: 7 g/10 min, density: 930 kg/m³, processing temperature: 310 degrees centigrade

Adhesive agent (b) : An ethylene-acrylic acid copolymer, content of the acrylic acid in the copolymer: 12 weight %, MFR: 10 g/10 min, density: 940 kg/m³, processing temperature: 270 degrees centigrade
Adhesive agent (c): An ethylene-methacrylic acid copolymer, content of the methacrylic acid in the copolymer: 15 weight %, MFR: 25 g/10 min, density: 940 kg/m³, processing temperature: 250 degrees centigrade

Adhesive agent (d): An ethylene-methacrylic acid copolymer, content of the methacrylic acid in the copolymer: 20 weight %, MFR: 60 g/10 min, density: 950 kg/m³, processing temperature: 250 degrees centigrade
Adhesive agent (e) : A metal salt of an ethylene-methacrylic acid copolymer, content of the methacrylic acid in the copolymer: 9 weight %, metal salt in which 17% of the methacrylic acid is neutralized with zinc, MFR: 5.5 g/10 min, density: 940 kg/m³, processing temperature: 303 degrees centigrade

Adhesive agent (f): A metal salt of an ethylene-methacrylic acid-isobutyl methacrylate copolymer, content of the methacrylic acid in the copolymer: 4 weight %, content of the isobutyl methacrylic acid: 15 weight %, metal salt in which 34% of the methacrylic acid is neutralized with zinc (Zn), MFR: 11.5 g/10 min, density: 930 kg/m³, processing temperature: 300 degrees centigrade

Adhesive agent (g) : A metal salt of an ethylene-methacrylic acid copolymer (g-1) (content of the methacrylic acid in the copolymer: 10 weight %, metal salt in which 50% of the methacrylic acid is neutralized with sodium (Na), MFR: 1.3g/10min, density: 940 kg/m³), a metal salt of an ethylene-methacrylic acid copolymer (g-2) (content of the methacrylic acid in the copolymer: 12 weight %, metal salt in which 36% of the methacrylic acid is neutralized with zinc (Zn), MFR: 1.5 g/10 min, density: 940 kg/m³), mixing (g-1)/(g-2) at a weight ratio of 60/40, processing temperature: 305 degrees centigrade

### Metal Foil

Electrolytic copper foil (thickness: 10 µm, 18 µm)

### Method of Measuring Physical Properties

### Melt Flow Rate (MFR)

In accordance with JIS K 7210-1999, it was measured at a measurement temperature of 190 degrees centigrade and a load of 2,160 g.

### Adhesive Strength of Copper Foil to Resin Film

A metal stack was allowed to stand at 40 degrees centigrade for 1 day, at 40 degrees centigrade for 2 days, and at 23 degrees centigrade for 7 days, and then adhesive strength of the copper foil to the resin film was confirmed under the following conditions by a T-peel test determined in JIS P8139.

### Peeling conditions: 300 mm/min, 15 mm wide

### Examples 1 and 2

A metal foil-attached film was produced so as to have a stack structure of a polyimide film (25)/AC layer/adhesive layer (30)/copper foil (10). The number in the parenthesis () denotes a thickness (µm) of the layer, and AC refers to an anchor coating agent (thickness of AC layer: 0.2 µm).
In each of Examples, a metal foil-attached film was produced by extrusion stacking a resin film coated with an anchor coating (AC) agent, an extrusion-molded adhesive film and a metal foil under the following conditions. Furthermore, before the formation of the adhesive layer on the anchor coating layer, the anchor coating layer surface was subjected to an ozone treatment (O₃ concentration: 25 g/m³, processing amount: 1 m³/h).
Adhesive strength of the copper foil to the resin film is shown in Table 1.

### Extrusion stacking Conditions

Device: A product of Sumitomo Heavy Industries Modern, Ltd.
Extruder: 65 mmϕ L/D=28
Screw: 3-stage type, CR=4.78
Die: 900 mm wide, inner Deckel type
Resin temperature: described as the processing temperature in respective adhesive layers
Processing speed: 80 m/minute

**Table-1 Adhesive Strength**

| | Adhesive agent | AC agent | Metal foil-attached film (N/15 mm) |
|---|---|---|---|
| | | | 40 degrees centigrade After 2 days |
| Example 1 | a | AC-b | 4.3 |
| Example 2 | b | AC-b | 5.7 |

From the results of Table 1, it was confirmed that the metal layer-attached film of the present invention was excellent in adhesion between the polyimide film and the copper foil because it was provided with the adhesive layer containing an ethylene-unsaturated carboxylic acid copolymer or a metal salt thereof. Also, as shown in Table 1, when the content of the carboxylic acid contained in the adhesive layer was increased, it was observed that adhesive strength of the adhesive layer to the copper foil constituting the metal-containing layer tended to be improved. This shows that, in case of a metal salt, although the amount of the carboxylic acid of a base polymer is the same, adhesion to a metal may be changed by adjusting the degree of neutralization and controlling the amount of a free carboxylic acid.

### Examples 3 to 9

A metal foil-attached film was produced so as to have a stack structure of a PET film (a) (100)/AC layer/adhesive layer (15) /copper foil (10). As the copper foil, an electrolytic copper foil was used. The number in the parenthesis () denotes a thickness (µm) of the layer, and AC refers to an anchor coating agent (thickness of AC layer: 0.2 µm).
In each of Examples 3 to 9, a metal layer-attached film was produced by extrusion stacking a resin film coated with an anchor coating (AC) agent, an extrusion-molded adhesive film and a metal foil under the same conditions as in Example 1. Adhesive strength of the copper foil to the resin film is shown in Table 2.

**Table-2 Adhesive Strength**

| | Adhesive agent | AC agent | Metal foil-attached film (N/15 mm) 23 | |
|---|---|---|---|---|
| | | | 40 degrees centigrade after 1 day | 23 degrees centigrade after 7 days |
| Example 3 | a | AC-a | 6.8 | 6.2 |
| Example 4 | b | AC-a | 5.7 | 7.2 |
| Example 5 | c | AC-a | 4.8 | 3.8 |
| Example 6 | d | AC-a | 3.0 | 1.8 |
| Example 7 | e | AC-a | 4.6 | 5.5 |
| Example 8 | f | AC-a | 6.7 | 6.7 |
| Example 9 | g | AC-a | 2.5 | 3.2 |

From the results of Table 2, it was confirmed that the metal layer-attached film of the present invention was excellent in adhesion between the PET film and the copper foil because it was provided with the adhesive layer containing an ethylene-unsaturated carboxylic acid copolymer or a metal salt thereof.

From the results of Examples 1 to 9, when the metal layer-attached film of the present invention is used for an electronic component such as a flexible printed wiring board, an RFID antenna board, a flat cable, a TAB tape, a COF tape or the like, it is guessed that adhesion between the resin film and the metal foil (circuit or wiring) is excellent. Thus, the product reliability of these electronic components is improved.

In addition, from the results of Examples 1 to 9, it is guessed that an electromagnetic wave shielding material using the metal layer-attached film of the present invention as an electromagnetic wave shielding film is excellent in adhesion between the resin film and the metal foil. Thus, the product reliability of the electromagnetic wave shielding material is improved.

### Example 10

In the metal layer-attached film obtained in each of Examples 1 to 9, a test pattern was formed from the copper foil under the following processing conditions, and the appearance of the pattern surface was observed. Observation of the pattern surface was carried out with respect to integrated wiring and independent wiring in the TD and MD directions. As a result, in L/S=75/75, the test pattern was accurately formed in both integrated wiring and independent wiring in the TD and MD directions.

### Processing Conditions

Exposing Conditions Exposure: 90 mJ
DFR in use: AQ-2558 (a product of Asahi Kasei Corporation)
Exposure Machine: DI Paragon-8000 (a product of Orbotech Ltd.)

### Developing Conditions

1% sodium carbonate solution, 28±2 degrees centigrade Etching Conditions
Beac System (ferric chloride, a product of Akeda Corporation), 45±3 degrees centigrade

### Peeling Conditions

Amine-based resist release agent, 55±3 degrees centigrade

### Observation of Appearance

Equipment Name: Hi-Scope Advanced 0611X05 (a product of Hirox Co., Ltd.)

From the results of Example 10, it was confirmed that the metal layer-attached film of the present invention was provided with the adhesive layer containing an ethylene-unsaturated carboxylic acid copolymer or a metal salt thereof and was excellent in adhesion to the metal layer, for example, a metal foil, so that an accurate pattern was formed. Also, it was confirmed that the product reliability was improved and the product yield was improved because peeling or the like was suppressed in a step of forming a wiring pattern or a circuit pattern from the metal foil.

### Examples 11 to 13

A metal foil-attached film was produced so as to have a stack structure of a resin film (25)/AC layer (0.2)/adhesive layer (23)/copper foil (18). The number in the parenthesis () denotes a thickness (µm) of the layer, and AC refers to an anchor coating agent.
In each of Examples 11 to 13, a metal layer-attached film was produced by extrusion stacking a resin film coated with an anchor coating (AC) agent, an extrusion-molded adhesive film and a metal foil under the following conditions. The kinds of the resin film, AC agent, adhesive agent and copper foil in use are shown in Table 3.

Extrusion stacking Conditions
Device: A product of Sumitomo Heavy Industries Modern, Ltd.
Extruder: 65mmϕ L/D=28
Screw: 3-stage type, CR=4.78
Die: 900 mm wide, inner Deckel type
Resin temperature: 260 degrees centigrade
Processing speed: 60 m/min

**Table 3 Metal foil-attached film**

| Layer structure (thickness: µm) | Resin film (25) | AC agent (0.2) | Adhesive agent (23) | Metal foil (18) |
|---|---|---|---|---|
| Example 11 | Polyimide film | AC-b | b | Electrolytic copper foil |
| Example 12 | PET film (b) | AC-b | b | Electrolytic copper foil |
| Example 13 | PEN film | AC-b | b | Electrolytic copper foil |

### Examples 14 to 16

A protective film (a coverlay film) was produced so as to have a stack structure of a resin film (25)/AC layer (0.2)/adhesive layer (35). The number in the parenthesis () denotes a thickness (µm) of the layer, and AC refers to an anchor coating agent.
In each of Examples 14 to 16, the protective film (coverlay film) was produced by extrusion stacking a resin film coated with an anchor coating (AC) agent and an extrusion-molded adhesive film under the same conditions as in Example 11. The kinds of the resin film, AC agent and adhesive agent in use are shown in Table 4.

**Table 4 Protective film (coverlay film)**

| Layer structure (thickness: µm) | Resin film (25) | AC agent (0.2) | Adhesive agent (35) |
|---|---|---|---|
| Example 14 | Polyimide film | AC-b | b |
| Example 15 | PET film (b) | AC-b | b |
| Example 16 | PEN film | AC-b | b |

### Examples 17 to 19

In the metal foil-attached film obtained in each of Examples 11 to 13, a test pattern was formed under the same conditions as in Example 10, and then stacked to the protective film (coverlay film) obtained in each of Examples 14 to 16 to carry out a test of the reliability as a flexible printed wiring board. Combinations of the metal foil-attached film and the protective film (coverlay film) are illustrated in Table 5.
As the reliability test items for use as a flexible printed wiring board, insulation resistance of a surface layer (measurement unit: Ω, after standard conditions and moisture absorption treatment), surface breakdown voltage (applied voltage: AC 100 to 500V, after standard conditions and moisture absorption treatment), peeling strength (measurement unit: N/mm, conductor and coverlay film), dimensional stability (MD direction, TD direction), bending test (IPC bending test), coverlay burying properties (existence of bubbles), and amount of bleeding an adhesive agent (measurement unit: µm) were evaluated. As a result of the evaluation, it was confirmed that all of the metal layer-attached films of the present invention had the reliability practically usable for the appropriate purposes. Furthermore, the aforementioned standard conditions refer to atmospheric conditions such as a temperature of 20 degrees centigrade and a relative humidity of 65%, while the conditions of the moisture absorption treatment refer to a temperature of 40 degrees centigrade, a relative humidity of 90% and the retention time of 96 hours.

**Table 5 Combinations of metal foil-attached film and protective film (coverlay film) stacked for reliability test of flexible printed wiring board**

| | Metal foil-attached film | Protective film (coverlay film) |
|---|---|---|
| Example 17 | Example 11 | Example 14 |
| Example 18 | Example 12 | Example 15 |
| Example 19 | Example 13 | Example 16 |

### Example 20

In the metal foil-attached films obtained in Examples 1 to 10, electromagnetic wave shielding properties were measured and as a result, excellent shielding properties were confirmed.

From the results of Example 20, it was confirmed that the film for shielding an electromagnetic wave of the present invention was provided with the adhesive layer containing an ethylene-unsaturated carboxylic acid copolymer or a metal salt thereof, was excellent in adhesion to the metal foil, and exhibited excellent electromagnetic wave shielding properties without peeling off the resin film layer and the metal foil even used for a long period of time. Also, it was confirmed that the film could be fast and continuously produced without using an organic solvent by the melt extrusion lamination method, so that it could be produced with a low environmental load as compared to the conventional production method.

Furthermore, the present invention includes the following embodiments.

[a] A metal layer-attached film for shielding an electromagnetic wave, including a resin film, a metal-containing layer, and an adhesive layer containing an ethylene-unsaturated carboxylic acid copolymer or a metal salt thereof which is provided between the resin film and the metal-containing layer and used for attaching them.

[b] The metal layer-attached film for shielding an electromagnetic wave according to [a], wherein, in the ethylene-unsaturated carboxylic acid copolymer or the metal salt thereof, the ethylene-unsaturated carboxylic acid copolymer is an ethylene-(meth)acrylic acid copolymer.

[c] The metal layer-attached film for shielding an electromagnetic wave according to [a] or [b], wherein the adhesive layer is obtained by extrusion molding the ethylene-unsaturated carboxylic acid copolymer or the metal salt thereof from a T die.

[d] The metal layer-attached film for shielding an electromagnetic wave according to any one of [a] to [c], wherein MFR of the ethylene-unsaturated carboxylic acid copolymer or the metal salt thereof is from 0.1 to 100 g/10 minutes, and the ethylene-unsaturated carboxylic acid copolymer or the metal salt thereof contains 1 to 30 weight % of the structural unit derived from an unsaturated carboxylic acid.

[e] The metal layer-attached film for shielding an electromagnetic wave according to any one of [a] to [d], wherein the metal-containing layer is a metal foil, a metal deposition film or a metal deposition layer.

[f] The metal layer-attached film for shielding an electromagnetic wave according to any one of [a] to [d], wherein a layer containing an anchor coating agent is provided between the resin film and the adhesive layer.

[g] A method for producing a metal layer-attached film for shielding an electromagnetic wave, including:
   heating an ethylene-unsaturated carboxylic acid copolymer or a metal salt thereof;
   forming an adhesive film by extrusion molding the melted ethylene-unsaturated carboxylic acid copolymer or the melted metal salt thereof from a T die; and
   stacking a metal-containing layer above a resin film through the adhesive film, in which these steps are continuously and repeatedly carried out.

[h] The method for producing a metal layer-attached film for shielding an electromagnetic wave according to [g], in which the metal-containing layer is a metal foil or a metal deposition film; and stacking the resin film and the metal-containing layer includes supplying the adhesive film between a long resin film and a long metal foil or a long metal deposition film, and stacking the resin film and the metal foil or the metal deposition film through an adhesive layer composed of the adhesive film by pressing the resin film and the metal foil or the metal deposition film.

[i] The method for producing a metal layer-attached film for shielding an electromagnetic wave according to [g], in which the metal-containing layer is a metal deposition layer; and stacking the resin film and the metal-containing layer includes depositing a metal on a surface of the adhesive film, and disposing a surface on which the metal of the adhesive film is not deposited to face the resin film for stacking them by pressing from both sides.

[j] The method for producing a metal layer-attached film for shielding an electromagnetic wave according to any one of [g] to [i], including coating an anchor coating agent onto a surface on which the adhesive film of the resin film is stacked before the stacking the resin film and the metal-containing layer.

[k] The method for producing a metal layer-attached film for shielding an electromagnetic wave according to any one of [g] to [j], in which MFR of the ethylene-unsaturated carboxylic acid copolymer or the metal salt thereof is from 0.1 to 100 g/10 minutes.

[1] The method for producing a metal layer-attached film for shielding an electromagnetic wave according to any one of [g] to [k], in which the ethylene-unsaturated carboxylic acid copolymer or the metal salt thereof contains 1 to 30 weight % of the structural unit derived from an unsaturated carboxylic acid.

[m] An electromagnetic wave shielding material formed by using the metal layer-attached film for shielding an electromagnetic wave according to any one of [a] to [f] having a metal-containing layer attached above a surface of a resin film through an adhesive layer, wherein a protective layer is arranged on a surface of the metal-containing layer which is not come into contact with the adhesive layer, through a second adhesive layer.

The present application claims priority based on Japanese patent application Nos. 2009-75067 and 2009-75068 filed on March 25, 2009, and incorporates herein the entire disclosure thereof by reference.

## Claims

1. A metal layer-attached film for an electronic component, comprising a metal-containing layer attached on at least one surface of a resin film through an adhesive layer, wherein said adhesive layer contains an ethylene-unsaturated carboxylic acid copolymer or a metal salt thereof.

2. The metal layer-attached film for an electronic component according to claim 1, wherein, in the ethylene-unsaturated carboxylic acid copolymer or the metal salt thereof, the ethylene-unsaturated carboxylic acid copolymer is an ethylene-(meth)acrylic acid copolymer.

3. The metal layer-attached film for an electronic component according to claim 1 or 2, wherein, in the ethylene-unsaturated carboxylic acid copolymer or the metal salt thereof, a metal cation constituting the metal salt is at least one kind selected from the group consisting of Na⁺, K⁺, Li⁺, Ca²⁺, Mg²⁺, Zn²⁺, Cu²⁺, Co²⁺, Ni²⁺, Mn²⁺ and Al³⁺.

4. The metal layer-attached film for an electronic component according to any one of claims 1 to 3, wherein the adhesive layer is obtained by extrusion molding the ethylene-unsaturated carboxylic acid copolymer or the metal salt thereof from a T die.

5. The metal layer-attached film for an electronic component according to any one of claims 1 to 4, wherein MFR of the ethylene-unsaturated carboxylic acid copolymer or the metal salt thereof is from 0.1 to 100 g/10 minutes.

6. The metal layer-attached film for an electronic component according to any one of claims 1 to 5, wherein the ethylene-unsaturated carboxylic acid copolymer or the metal salt thereof contains 1 to 30 weight % of the structural unit derived from an unsaturated carboxylic acid.

7. The metal layer-attached film for an electronic component according to any one of claims 1 to 6, wherein a layer containing an anchor coating agent is provided between the resin film and said adhesive layer.

8. The metal layer-attached film for an electronic component according to any one of claims 1 to 7, obtained by extrusion molding the heated ethylene-unsaturated carboxylic acid copolymer or the heated metal salt thereof from a T die to give an adhesive film, and stacking the adhesive film on the resin film.

9. The metal layer-attached film for an electronic component according to any one of claims 1 to 8, wherein the metal-containing layer is a metal foil, a metal deposition film or a metal deposition layer.

10. The metal layer-attached film for an electronic component according to any one of claims 1 to 8, wherein the metal-containing layer is a copper foil.

11. The metal layer-attached film for an electronic component according to any one of claims 1 to 10, wherein the resin film contains at least one kind selected from the group consisting of a polyimide resin, a polyethylene naphthalate resin and a polyethylene terephthalate resin.

12. The metal layer-attached film for an electronic component according to any one of claims 1 to 11, wherein the metal-containing layer constitutes a metal layer of a flexible printed wiring board, an RFID antenna, a TAB tape, a COF tape, a flexible flat cable or a copper-clad stack as an electronic component.

13. The metal layer-attached film for an electronic component according to any one of claims 1 to 11, constituting an electromagnetic wave shielding material blocking an electromagnetic wave generated from the electronic component.

14. A method for producing a metal layer-attached film for an electronic component, comprising:
heating an ethylene-unsaturated carboxylic acid copolymer or a metal salt thereof;
forming an adhesive film by extrusion molding the melted ethylene-unsaturated carboxylic acid copolymer or the melted metal salt thereof from a T die; and
stacking a metal-containing layer on a resin film through said adhesive film, in which these steps are continuously and repeatedly carried out.

15. The method for producing a metal layer-attached film for an electronic component according to claim 14, in which a metal-containing layer is a metal foil or a metal deposition film; wherein the stacking the resin film and the metal-containing layer comprising:
supplying the adhesive film between a long resin film and a long metal foil or a long metal deposition film, and
pressing the resin film and the metal foil or the metal deposition film for stacking the resin film and the metal foil or the metal deposition film through an adhesive layer composed of the adhesive film.

16. The method for producing a metal layer-attached film for an electronic component according to claim 14, in which the metal-containing layer is a metal deposition layer; wherein the stacking the resin film and the metal-containing layer comprising:
depositing a metal on a surface of the adhesive film, and
disposing a surface on which the metal of the adhesive film is not deposited to face the resin film for stacking them by pressing from both sides.

17. The method for producing a metal layer-attached film for an electronic component according to any one of claims 14 to 16, comprising coating an anchor coating agent onto a surface on which the adhesive film of the resin film is stacked before the stacking the resin film and the metal-containing layer.

18. The method for producing a metal layer-attached film for an electronic component according to any one of claims 14 to 17, in which MFR of the ethylene-unsaturated carboxylic acid copolymer or the metal salt thereof is from 0.1 to 100 g/10 minutes.

19. The method for producing a metal layer-attached film for an electronic component according to any one of claims 14 to 18, in which the ethylene-unsaturated carboxylic acid copolymer or the metal salt thereof contains 1 to 30 weight % of the structural unit derived from an unsaturated carboxylic acid.

20. An RFID antenna formed by using the metal layer-attached film for an electronic component according to any one of claims 1 to 11 having a metal-containing layer attached on one surface of a resin film through an adhesive layer, comprising:
an antenna formed from the metal-containing layer,
a semiconductor chip mounted on the resin film, and
a protective film covering the antenna and the semiconductor chip.

21. A copper-clad stack formed by using the metal layer-attached film for an electronic component according to any one of claims 1 to 11 having a metal-containing layer attached on one surface of a resin film through an adhesive layer, wherein the metal layer-attached film is stacked above at least one surface of a base substrate through an adhesive layer such that the resin film is located on the base substrate side, and the metal-containing layer constitutes a patterned wiring layer.

22. A flexible printed wiring board formed by using the metal layer-attached film for an electronic component according to any one of claims 1 to 11 having a metal-containing layer attached on at least one surface of a resin film through an adhesive layer, comprising:
a wiring layer formed from the metal-containing layer,
a protective film formed on the wiring layer and the resin film, and
an opening exposing the wiring layer on a bottom surface which is formed on the protective film.

23. A TAB tape formed by using the metal layer-attached film for an electronic component according to any one of claims 1 to 11 having a metal-containing layer attached on one surface of a resin film through an adhesive layer, comprising:
a device hole penetrating the metal layer-attached film and
a wiring layer formed from the metal-containing layer,
wherein edges of the wiring layer are caused to protrude to the inside of the device hole and electrically connected to a semiconductor chip to be mounted inside the device hole.

24. A COF tape formed by using the metal layer-attached film for an electronic component according to any one of claims 1 to 11 having a metal-containing layer attached on one surface of a resin film through an adhesive layer, comprising:
a wiring layer formed from the metal-containing layer,
wherein edges of said wiring layer are electrically connected to a semiconductor chip.

25. A flexible flat cable formed by using the metal layer-attached film for an electronic component according to any one of claims 1 to 11 having a metal-containing layer attached on at least one surface of a resin film through an adhesive layer, comprising:
a wiring layer formed from the metal-containing layer, and
an insulating film covering the wiring layer and the resin film.

26. An electromagnetic wave shielding material formed by using the metal layer-attached film for an electronic component according above any one of claims 1 to 11 having a metal-containing layer attached above a surface of a resin film through an adhesive layer, wherein a protective layer is arranged on a surface of the metal-containing layer which is not come into contact with the adhesive layer, through a second adhesive layer.
